# DEMANDE DE BREVET EUROPEEN

(11) **EP 4 672 895 A1**
(43) Date de publication de la demande: **31.12.2025**
(21) Numéro de dépôt: 25183180.6
(22) Date de dépôt: 17.06.2025
(51) Int. Cl.: H10B 63/10, H10N 70/20

(54) **CELLULE MEMOIRE**

(30) Priorité: 28.06.2024 FR 2407027
(71) Demandeur: STMicroelectronics International N.V., 1228 Plan-les-Ouates, Geneva (CH)
(72) Inventeur: BACQUIE, Valentin, 38000 GRENOBLE (FR); RUBECK, Sarah, 73110 ARVILLARD (FR)
(74) Mandataire: Cabinet Beaumont

(57) **Abrégé**

La présente description concerne un dispositif électronique (40) comportant une pluralité de cellules mémoires (M) organisées selon une matrice, formant des lignes et des colonnes,
chaque cellules mémoire (M) comprenant un empilement d'un élément résistif chauffant (27), d'une couche en un matériau à changement de phase (25), d'une électrode supérieure (31) et d'une couche de masquage (43),
la couche en le matériau à changement de phase (25), l'électrode supérieure (31) et la couche de masquage (43), étant commune aux cellules mémoires d'une même ligne et recouverts par une couche d'encapsulation (35), la couche d'encapsulation (35) recouvrant une face supérieure de la couche de masquage (43) et des flancs latéraux de la couche de masquage (43), de l'électrode supérieure (31) et de la couche en le matériau à changement de phase (25),
dans lequel la couche de masquage (43) a une épaisseur inférieure à 15 nm.

## Description

### Domaine technique

La présente description concerne de façon générale le domaine des dispositifs électroniques et vise plus particulièrement le domaine des puces électroniques comportant un circuit mémoire, à base d'un matériau à changement de phase, et leurs procédés de fabrication.

### Technique antérieure

Un matériau à changement de phase est un matériau ayant la capacité de changer de phase sous l'effet de la chaleur et plus particulièrement de commuter entre un état cristallin et un état amorphe, plus fortement résistif que l'état cristallin. Ce phénomène est utilisé pour définir deux états mémoires, par exemple 0 et 1, différenciés par la résistance mesurée à travers le matériau à changement de phase.

Il existe un besoin d'amélioration des puces électroniques comportant un circuit mémoire à base d'un matériau à changement de phase.

### Résumé de l'invention

Pour cela, un mode de réalisation prévoit un dispositif électronique comportant une pluralité de cellules mémoires organisées selon une matrice, formant des lignes et des colonnes,
chaque cellules mémoire comprenant un empilement d'un élément résistif chauffant, d'une couche en un matériau à changement de phase, d'une électrode supérieure et d'une couche de masquage,
la couche en le matériau à changement de phase, l'électrode supérieure et la couche de masquage, étant commune aux cellules mémoires d'une même ligne et recouverts par une couche d'encapsulation, la couche d'encapsulation recouvrant une face supérieure de la couche de masquage et des flancs latéraux de la couche de masquage, de l'électrode supérieure et de la couche en le matériau à changement de phase,
dans lequel la couche de masquage a une épaisseur inférieure à 15 nm.

Selon un mode de réalisation, la couche de masquage a une épaisseur de l'ordre de 5 nm.

Selon un mode de réalisation, la couche de masquage est en nitrure de silicium.

Selon un mode de réalisation, la couche de masquage et la couche d'encapsulation sont en un nitrure de silicium ayant la même stœchiométrie.

Selon un mode de réalisation, la couche de masquage et la couche d'encapsulation ont une masse volumique inférieure à 2,2 g/cm3.

Selon un mode de réalisation, la couche de masquage ou la couche d'encapsulation est en un empilement de plusieurs sous-couches.

Selon un mode de réalisation, la couche de masquage et la couche d'encapsulation sont traversées par un via conducteur, le via conducteur étant en contact avec l'électrode supérieure.

Un autre mode de réalisation prévoit un procédé de fabrication d'un dispositif électronique comportant une pluralité de cellules mémoires organisées selon une matrice, formant des lignes et des colonnes, le procédé comportant les étapes de :
a) formation d'un empilement d'un élément résistif, d'une couche en un matériau à changement de phase et d'une électrode supérieure ;
b) dépôt d'une couche de masquage sur l'empilement susmentionné avec une épaisseur inférieure à 20 nm ;
c) gravure de la couche de masquage et de l'empilement de façon à créer, dans la couche en le matériau à changement de phase, l'électrode supérieure et la couche de masquage, des lignes ; et
d) dépôt d'une couche d'encapsulation recouvrant une face supérieure de la couche de masquage et des flancs latéraux de la couche de masquage, de l'électrode supérieure et de la couche en le matériau à changement de phase.

Selon un mode de réalisation, la couche de masquage est, à l'étape b), déposée selon une méthode de dépôt conforme.

Selon un mode de réalisation, la couche de masquage est, à l'étape b), déposée selon une méthode de dépôt nanométrique.

Selon un mode de réalisation, la couche de masquage est, à l'étape b), déposée selon une méthode de dépôt chimique en phase vapeur assisté par plasma, cette méthode étant pulsée.

Selon un mode de réalisation, lors de l'étape b), le plasma est activé par impulsions d'une puissance comprise entre 80 W et 200 W.

Selon un mode de réalisation, l'étape b) a une durée supérieure à 30 secondes.

Selon un mode de réalisation, lors de l'étape b), les impulsions du plasma ont une fréquence comprise entre 800 Hz et 1500 Hz.

Selon un mode de réalisation, le procédé comporte, entre les étapes b) et c), une étape de traitement thermique de la couche de masquage.

Selon un mode de réalisation, la couche d'encapsulation et la couche de masquage sont déposées selon la même méthode de dépôt.

Un autre mode de réalisation prévoit un procédé d'utilisation d'un dispositif électronique tel que défini ci-dessus, comportant l'application d'un courant dans l'élément résistif chauffant de l'une des cellules mémoires, d'où il résulte un changement de phase cristalline de la couche en le matériau à changement de phase de la cellule mémoire, permettant le stockage d'un bit de données.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est une vue en coupe, partielle et schématique, d'un exemple d'un dispositif électronique ;
la figure 2A et la figure 2B sont des vues en coupe, partielles et schématiques, du dispositif de la figure 1 ;
la figure 3, la figure 4, la figure 5 et la figure 6 sont des vues en coupe, partielles et schématiques, illustrant des étapes d'un exemple de procédé de fabrication d'un autre dispositif électronique selon un mode de réalisation.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % ou à 10° près, de préférence à 5 % ou à 5° près.

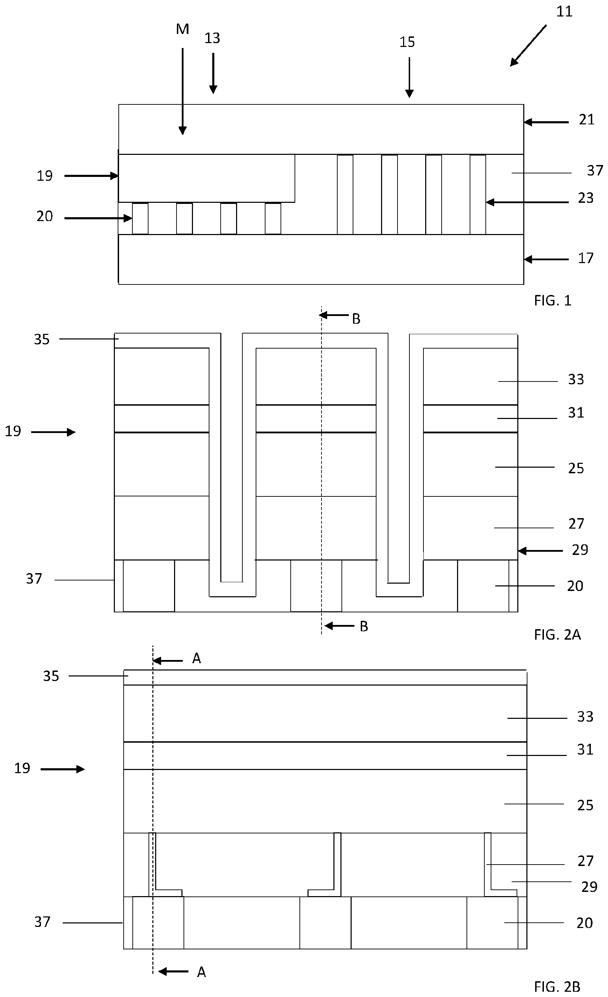

La figure 1 est une vue en coupe, partielle et schématique, d'un exemple d'un dispositif électronique comportant un élément mémoire.

Le dispositif 11 est par exemple une puce électronique.

Le dispositif 11 comprend par exemple un circuit mémoire 13 et un circuit logique 15. Le circuit mémoire 13 et le circuit logique 15 sont par exemple formés sur et/ou dans un substrat semiconducteur 17. A titre d'exemple, le substrat 17 est en silicium ou à base de silicium.

A titre d'exemple, le dispositif 11 comprend, dans chacun des circuits mémoire 13 et logique 15, une pluralité de transistors, non représentés, formés dans et sur le substrat 17. Les transistors sont par exemple agencés en matrice comprenant des lignes et des colonnes.

Dans le circuit mémoire, les transistors sont par exemple surmontés d'un élément mémoire 19 comportant une pluralité de cellules mémoires M, chaque transistor étant associé à une cellule mémoire M. A titre d'exemple, dans le circuit mémoire 13, les transistors sont des transistors de sélection de la cellule mémoire M. A titre d'exemple, le substrat 17 est relié à l'élément mémoire 19 par l'intermédiaire de vias conducteurs 20. A titre d'exemple, chaque via 20 relie un transistor de sélection à une cellule mémoire M qui lui est associée. A titre d'exemple, les vias conducteurs 20 sont par exemple en un matériau métallique. Les vias conducteurs 20 sont par exemple en cuivre, en cobalt ou en tungstène.

Les cellules mémoires M sont des cellules mémoire à changement de phase, c'est-à-dire comportant une couche en un matériau à changement de phase.

Dans le circuit mémoire 13, les cellules mémoires M de l'élément mémoire 19 sont organisées, en vue de dessus, selon une matrice de lignes et de colonnes. On parle respectivement de lignes de mots (wordlines) et de lignes de bits (bitlines). A titre d'exemple, chaque cellule mémoire M est situé à l'intersection d'une ligne de bits et d'une ligne de mots. A titre d'exemple, la matrice formée par les cellules mémoires M est identique à la matrice formée par les transistors.

A titre d'exemple, le dispositif comprend, dans les circuits mémoire 13 et logique 15, un empilement d'interconnexion 21. A titre d'exemple, l'empilement d'interconnexion est formé sur la face supérieure de l'élément mémoire 19. Dans cet exemple, l'élément mémoire 19 est ainsi formé entre l'empilement d'interconnexion 21 et le substrat 17. L'empilement d'interconnexion 21 recouvre par exemple toute la surface du substrat 17.

L'empilement d'interconnexion 21 est par exemple composé d'une succession de niveaux, chaque niveau comportant une succession de couches isolantes. A titre d'exemple, l'empilement d'interconnexion 21 a une épaisseur comprise entre 300 nm et 800 nm, par exemple comprise entre 400 nm et 700 nm, par exemple de l'ordre de 500 nm. Chaque niveau comprend, par exemple, des vias conducteurs et des pistes conductrices traversant ledit niveau. Les vias et pistes conductrices sont par exemple en un matériau métallique, par exemple en cuivre ou en tungstène.

A titre d'exemple, le substrat 17, plus précisément les transistors disposés dans le substrat 17, sont reliés électriquement à l'empilement d'interconnexion 21 par l'intermédiaire de vias conducteurs 23. Les vias contacteurs 23 sont par exemple en contact, par leurs faces inférieures, avec les transistors disposés dans le substrat 17 et par leurs faces supérieures, avec l'empilement d'interconnexion 21. A titre d'exemple, les vias conducteurs 23 sont par exemple en un matériau métallique. Les vias conducteurs 23 sont par exemple en cuivre, en cobalt ou en tungstène.

Les vias conducteurs 23 s'étendent ainsi de la face supérieure du substrat 17 à la face inférieure de l'empilement d'interconnexion 21. La hauteur des vias conducteurs 23 est alors identique à l'épaisseur de l'élément mémoire 19 à laquelle est ajoutée la hauteur des vias 20.

A titre d'exemple, les vias 23 traversent, entre l'empilement d'interconnexion 21 et le substrat 17, une couche isolante 37. En outre, la couche 37 est, par exemple, également traversée par les vias 20.

La figure 2A et la figure 2B sont des vues en coupe, partielles et schématiques, d'un exemple de l'élément mémoire 19 de la figure 1. Plus particulièrement, la figure 2A est une vue en coupe selon le plan de coupe AA de la figure 2B et la figure 2B est une vue selon le plan de coupe BB de la figure 2A

Plus particulièrement, en figure 2A, trois cellules mémoires M de l'élément mémoire 19 sont au moins partiellement représentées. A titre d'exemple, les cellules mémoires M illustrées en figure 2A sont des cellules mémoires M d'une même ligne de mots et correspondent à trois cellules mémoires M de lignes de bits différentes.

Chaque cellules M comprend une couche 25 en un matériau à changement de phase, par exemple un matériau chalcogénure, par exemple un alliage de germanium, antimoine et tellure (GeSbTe) dit GST. La couche 25 a, par exemple, une épaisseur comprise entre 30 nm et 100 nm, par exemple de l'ordre de 50 nm. Les cellules mémoires M d'une même ligne de bits comprennent par exemple une couche 25 commune. Ainsi, le dispositif 11 comprend, dans l'élément mémoire 19, par exemple autant de couche 25 que de lignes de bits. Chaque couche 25 s'étend ainsi dans la direction des lignes de bits.

Dans chaque cellule mémoire M, le matériau à changement de phase est contrôlé par un élément résistif métallique chauffant 27 situé sous le matériau à changement de phase. L'élément 27 est par exemple en contact, par sa face supérieure, avec la face inférieure de la couche 25. L'élément 27 est par exemple entouré latéralement d'une couche en un isolant thermique 29. Par exemple, chaque élément 27 a une forme de "L" dans le plan de coupe de la figure 2B. A titre d'exemple, l'élément 27 est en nitrure de tantale ou en nitrure de titane silicium. A titre d'exemple, la couche 29 est en carbonitrure de silicium, en nitrure de silicium ou en oxyde de silicium. A titre d'exemple, les éléments chauffants 27 sont en contact avec les vias 20. A titre d'exemple, chaque élément chauffant 27 a, par exemple, une hauteur comprise entre 30 nm et 100 nm, par exemple de l'ordre de 60 nm.

La couche 25 est surmontée par une couche 31, par exemple en un matériau conducteur, par exemple en un matériau métallique. Plus précisément, la face supérieure de chaque couche 25 est par exemple au moins partiellement recouverte, par exemple entièrement recouverte, par une couche 31. Chaque couche 31 s'étend de préférence, dans la direction des lignes de bits, sur toute la longueur de la couche 25. La couche 31 est par exemple en nitrure de titane. A titre d'exemple, la couche 31 a une épaisseur comprise entre 10 nm et 50 nm, par exemple de l'ordre de 20 nm.

A titre d'exemple, dans chaque cellule mémoire M, l'élément métallique 27 et la couche 31 forment respectivement une électrode inférieure et une électrode supérieure de la cellule mémoire M, et plus précisément des électrodes de l'élément résistif à résistance variable formé par la couche 25 en le matériau à changement de phase. Les cellules mémoires M d'une même ligne de bits sont surmontées d'une même couche 31. En d'autres termes, les électrodes supérieures 31 des cellules mémoires M d'une même ligne de bits sont interconnectées.

La couche 31 est, par exemple surmontée par une couche de masquage 33, par exemple en un matériau isolant, par exemple en un matériau diélectrique. La couche de masquage 33 est par exemple en un nitrure, par exemple en nitrure de silicium. La face supérieure de chaque couche 31 est par exemple au moins partiellement recouverte, par exemple entièrement recouverte, par une couche 33. Chaque couche 33 s'étend de préférence, dans la direction des lignes de bits, sur toute la longueur de la couche 31. A titre d'exemple, la couche 33 a une épaisseur de l'ordre de 25 nm.

La couche 33 est par exemple déposée par une méthode de dépôt chimique en phase vapeur assisté par plasma (PECVD, de l'anglais "Plasma-Enhanced Chemical Vapor Deposition"). La méthode de dépôt PECVD consiste en la génération d'un plasma qui réagissant avec un gaz précurseur donne lieu à une ou des nouvelles espèces chimiques qui vont interagir avec un substrat en s'y accrochant pour former un dépôt. Lors du dépôt de la couche 33, le gaz précurseur est de silane (SiH₄), de l'ammoniac (NH₃), du diazote (N₂) ou une combinaison de deux ou plus de ces éléments. Lors de cette étape, la puissance du plasma est comprise entre 400 W et 600 W, par exemple de l'ordre de 500 W. La durée du dépôt de la couche 33 est par exemple compris entre 5 secondes et 6 secondes.

Chaque cellule mémoire M est par exemple recouverte par une couche d'encapsulation 35 protégeant, par exemple la couche 25 en le matériau à changement de phase de l'oxydation. A titre d'exemple, la couche d'encapsulation 35 recouvre la face supérieure de la couche 33 et les flancs des couches 33, 31, 25 et 29. La couche d'encapsulation 35 est par exemple en un matériau diélectrique. La couche d'encapsulation 35 est par exemple en un nitrure, par exemple en nitrure de silicium. La couche d'encapsulation 35 a par exemple une épaisseur comprise entre 20 nm et 50 nm, par exemple de l'ordre de 33 nm.

Les couches 35 et 33 sont déposées par des méthodes de dépôt différentes. A titre d'exemple, les couches 35 et 33 sont en le même matériau, par exemple en nitrure de silicium, mais ont des stœchiométries différentes, c'est à dire que les taux d'azote et de silicium dans les deux couches 33 et 35 sont différents.

Les cellules mémoires M sont, par exemple, chacune reliées électriquement au transistor qui lui est associé par l'intermédiaire du via 20. Les vias 20 traversent par exemple la couche isolante 37. Les cellules mémoires M reposent ainsi sur la face supérieure de la couche 37 et des vias 20.

Dans l'exemple des figures 2A et 2B, l'épaisseur des cellules mémoires M correspond ainsi au cumul des épaisseurs des couches 35, 33, 31, 25 et 29. La hauteur des vias conducteurs 23 illustrée en figure 1 est alors directement liée à l'épaisseur des couches susmentionnées.

Dans l'exemple des figures 1 et 2, les vias 23 ont par exemple une hauteur supérieure ou égale à 250 nm. Or, dans un circuit logique comportant de tels vias, plus la hauteur des vias est importante plus la résistance des vias est forte et plus la performance du circuit logique 15 est faible.

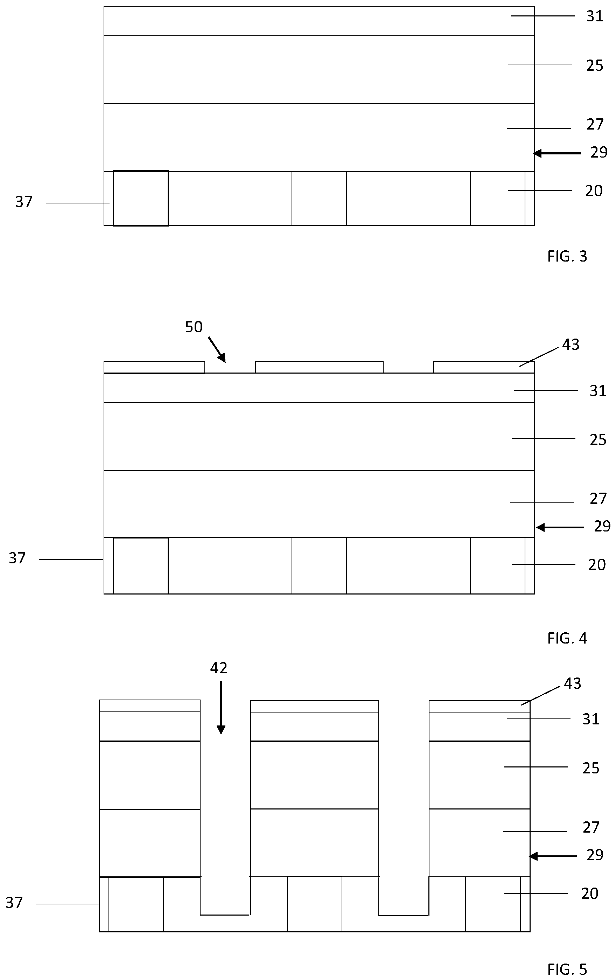

La figure 3, la figure 4, la figure 5 et la figure 6 sont des vues en coupe, partielles et schématiques, illustrant des étapes d'un exemple d'un procédé de fabrication d'un dispositif électronique selon un mode de réalisation.

Plus particulièrement, les figures 3 à 6, illustrent des étapes d'un procédé de fabrication d'un dispositif 40 différent du dispositif 11 illustré en figures 1 et 2, en ce que la couche de masquage 33 est remplacée par une couche de masquage 43 ayant une épaisseur inférieure à 15 nm.

La figure 3 illustre une structure de départ comportant, sur la face supérieure de la couche isolante 37 traversée par les vias 20, la couche isolante 29 comportant une pluralité d'éléments chauffants 27. La structure de départ illustrée en figure 3 comporte, de plus, sur et en contact avec la face supérieure de la couche 29 et des éléments 27, la couche 25 en le matériau à changement de phase. En outre la structure de départ comporte, sur et en contact avec la face supérieure de la couche 25, la couche conductrice 31.

Dans cette structure, les couches 29, 25 et 31 s'étendent, par exemple, sur toute la surface de la couche 37.

La figure 4 illustre une structure obtenue à l'issue d'une étape de dépôt de la couche de masquage 43 sur la face supérieure de la structure illustrée en figure 3.

La couche de masquage 43 est, par exemple en un matériau isolant, par exemple en un matériau diélectrique. La couche de masquage 43 est par exemple en un nitrure, par exemple en nitrure de silicium.

Lors de cette étape, la couche 43 est déposée par une méthode de dépôt nanométrique. La couche 43 est par exemple déposée par une méthode de dépôt PECVD pulsé. Cette méthode de dépôt est similaire à la méthode de dépôt PECVD à la différence près que la puissance du plasma n'est pas constante sur toute la durée du dépôt. La puissance du plasma est, dans cette méthode, pulsée c'est à dire qu'elle suit des impulsions. Dans cette méthode, la puissance du plasma alterne entre une puissance haute et une puissance basse. A titre d'exemple, la puissance haute est comprise entre 80 W et 200 W, par exemple de l'ordre de 107 W. A titre d'exemple, la puissance basse est sensiblement nulle. Lors du dépôt de la couche 43, le gaz précurseur est de trisilylamine, de l'ammoniac (NH₃), du diazote (N₂) ou une combinaison de deux ou plus de ces éléments.

La fréquence des impulsions est, dans cette méthode, comprise entre 800 Hz et 1500 Hz, par exemple de l'ordre de 1000 Hz. A titre d'exemple, sur la durée du dépôt de la couche 43, le plasma est allumé, par exemple entre 5 % et 20 % du temps, par exemple environ 10 % du temps. Le dépôt de la couche 43 a une durée supérieure à 30 secondes, par exemple comprise entre 60 secondes et 120 secondes et est, par exemple de l'ordre de 91 secondes. Lors de cette étape, la couche 43 est déposée avec une épaisseur inférieure à 15 nm, par exemple de l'ordre de 11 nm.

A titre d'exemple, un dépôt de 11 nm de la couche 43 est réalisé lorsque :
- la puissance du plasma est, dans sa valeur haute, de 107 W ;
- la fréquence de pulsation est de 1000 Hz ;
- le plasma est activé pendant 10 % du temps ; et
- la durée du dépôt est de 91 secondes.

A titre d'exemple, à l'issue de l'étape de dépôt de la couche 43, celle-ci subit une étape de traitement permettant de densifier la couche 43 en azote. En d'autres termes, la couche 43 subit, à l'issue de son dépôt, une étape lui permettant de se charger davantage en azote. A titre d'exemple, ce traitement consiste en une exposition de la surface de la couche 43 à un plasma de diazote et d'hélium.

L'enchainement d'un dépôt selon la méthode de PECVD pulsé suivie d'une étape de traitement correspond à un cycle de dépôt par PECVD pulsé.

En variante, la couche 43 est déposée par une méthode de dépôt de couches atomiques (ALD, de l'anglais "Atomic Layer Deposition").

A l'issue de l'étape de dépôt de la couche 43 pleine plaque sur la face supérieure de la couche 31, la couche 43 est gravée localement de façon à créer, dans la couche 43, des ouvertures 50 traversantes s'étendant jusqu'à la surface de la couche 31.

La figure 5 illustre une structure obtenue à l'issue d'une étape de formation de tranchées 42, dans la structure illustrée en figure 4, par gravure à travers la couche de masquage 43. Plus particulièrement, lors de cette étape, la formation des tranchées 42 est réalisée alors que la couche de masquage 43 joue le rôle de masque de gravure.

A titre d'exemple, les tranchées 42 sont formées à partir de la face supérieure de la couche 31 dans l'empilement des cellules mémoires M jusqu'à atteindre la couche isolante 37. A titre d'exemple, la gravure est arrêtée lorsque les tranchées 42 débouchent dans la couche isolante 37.

Lors de cette étape, la formation des tranchées 42 permet de former les lignes de bits.

A l'issue de cette étape, la couche 43 a une épaisseur réduite par rapport à ce qui a été décrit en relation avec la figure 4. La couche 43 a, en effet, à l'issue de cette étape, une épaisseur inférieure à 10 nm, par exemple inférieure à 7 nm, par exemple de l'ordre de 5 nm.

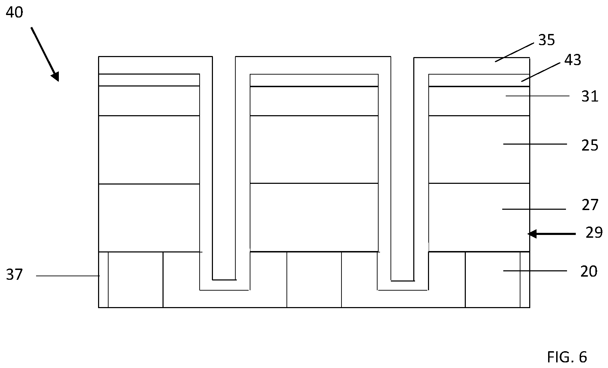

La figure 6 illustre une structure obtenue à l'issue d'une étape de dépôt d'une couche d'encapsulation 35 sur la face supérieure de la structure illustrée en figure 5 de façon à former le dispositif 40.

Plus particulièrement, lors de cette étape, on vient déposer la couche 35 sur la face supérieure de la couche 43 et dans les tranchées 42, sur les flancs latéraux de l'empilement des couches 43, 31, 25 et 29. A titre d'exemple, la couche 35 est en outre déposée dans le fond des tranchées sur la face supérieure de la couche 37.

A titre d'exemple, la méthode de dépôt de la couche 35 est similaire, par exemple identique à la méthode de dépôt de la couche 43 illustrée en relation avec la figure 4.

La couche 35 est par exemple déposée selon une méthode de dépôt conforme. A titre d'exemple, la couche 35 est déposée selon une méthode de dépôt PECVD pulsé similairement à ce qui a été décrit pour la couche 43. A titre d'exemple, le dépôt de la couche 35 comprend plusieurs cycles de dépôt par PECVD pulsé. A titre d'exemple, le dépôt de la couche 35 comprend trois cycles de dépôt par PECVD pulsé.

A titre d'exemple, la couche 35 et la couche 43 ont, à l'issue de cette étape, la même composition. A titre d'exemple, les couches 43 et 35 ont des stœchiométries identiques, c'est-à-dire que le taux d'azote et taux de silicium dans les deux couches 43 et 35 sont identiques. Un avantage est que ceci permet de simplifier la gravure. Il est en effet plus simple d'avoir un seul type de couche à graver plutôt qu'un bi-matériau. Ceci permet notamment d'éviter ou de limiter les problématiques de double pente liées à la mise en oeuvre d'étapes de gravure distinctes, ou l'utilisation de différentes solutions chimiques pour réaliser les gravures.

Selon un aspect des modes de réalisation décrits, le nitrure de silicium des couches 35 et 43 a une densité inférieure à 2,2, par exemple inférieure à 2,15. La densité correspond ici à la masse volumique du matériau exprimée en g/cm³, divisée par une masse volumique de référence égale ici à 1 g/cm³. Les couches 35 et 43 ont ainsi une masse volumique inférieure à 2,2 g/cm³, par exemple inférieure à 2,15 g/cm³.

Selon un aspect des modes de réalisation décrits, les couches 35 et 43 peuvent chacune être en une pluralité de sous-couches et correspondre à un empilement d'une pluralité de sous-couches en nitrure de silicium formées au cours de cycles de dépôts successifs.

A l'issue de cette étape, les couches 35 et 43 sont par exemple gravées du côté de la face supérieure de chaque cellule mémoire M. Lors de cette étape, on vient exposer une partie de la face supérieure de la couche 31 et y former un via conducteur, non représenté, en contact avec la couche 31. Lors de cette étape, les couches 43 et 35 sont par exemple retirées localement.

De nombreuses applications sont susceptibles de tirer profit des avantages procurés par le dispositif électronique 11, ce dispositif 11 pouvant ainsi être intégré dans divers types de composants.

À titre d'exemple, le dispositif 11 peut être intégré dans un composant destiné à l'industrie automobile. L'électrification des véhicules automobiles cause une forte augmentation du nombre de composants électroniques présents dans les véhicules. Le composant comprend par exemple des thyristors, des redresseurs, des diodes de suppression de tensions transitoires, des modules, etc. destinés à être incorporés dans lesdits véhicules. Par ailleurs, l'aide à la conduite et l'automatisation de la conduite sont à l'origine d'une augmentation du nombre de composants électroniques dans les véhicules. Le composant comprend par exemple des diodes de suppression de tensions transitoires, une protection contre les décharges électrostatiques et des filtres de mode commun permettant de protéger le composant contre des risques électriques.

À titre d'exemple, le dispositif 11 peut être intégré dans un composant destiné à l'industrie. En particulier, le composant est par exemple utilisé pour le développement des énergies vertes ou pour l'électrification d'infrastructures, par exemple pour des bornes de recharge ou pour la collecte d'énergie solaire. Le composant peut également être utilisé dans le domaine de l'internet des objets ou dans le domaine des maisons connectées. Le composant est par exemple destiné à être mis en œuvre dans des circuits d'alimentation en énergie électrique d'équipements, comprenant par exemple des thyristors 800 V ou 1 200 V, des diodes 1 200 V ultrarapides et au carbure de silicium, des diodes de suppression de tensions transitoires et des protections contre les décharges électrostatiques. Le composant peut également être utilisé pour la mise en œuvre de systèmes d'informatique dans le nuage, de réseaux de communication radiofréquence 5G, de centres de données et de serveurs. Le composant comprend par exemple des matériaux à large bande interdite.

À titre d'exemple, le dispositif 11 peut être intégré dans un composant destiné à être utilisé dans l'électronique personnelle, par exemple dans le but d'augmenter un volume d'informations échangées par communication radiofréquence, dans des systèmes de communication 5G, ou plus généralement dans tout composant connecté. Le composant est par exemple un téléphone mobile, ou smartphone, ou fait partie d'un réseau de l'internet des objets. Le composant est par exemple connecté par 5G, par WiFi ou par communication large bande. Le composant comprend par exemple des interfaces à haut débit, par exemple avec un filtrage avancé et une protection contre les décharges électrostatiques.

À titre d'exemple, le dispositif 11 peut être intégré dans un composant destiné à être utilisé dans des équipements de communication, ou dans des ordinateurs et des périphériques. Le composant est par exemple utilisé dans des infrastructures 5G et des centres de données dédiés. Le composant comprend par exemple des diodes en carbure de silicium, des transistors de puissance Schottky, des protections contre les décharges électrostatiques et des diodes de suppression des tensions transitoires. Le composant peut également être utilisé dans des satellites comprenant par exemple des composants passifs intégrés pour des applications radiofréquence.

Un avantage du présent mode de réalisation est qu'il permet de réduire l'épaisseur de la couche 43 et ainsi réduire l'épaisseur de l'élément mémoire 19.

Un autre avantage du présent mode de réalisation est qu'il permet de réduire l'éloignement entre le substrat 17 et l'empilement d'interconnexion 21 et la hauteur des vias 23 dans le circuit logique du dispositif 40. Cela engendre une diminution de la résistance des vias 23. La diminution d'épaisseur de la couche 33 réduit en outre la taille (et donc la résistance) des vias qui connectent les éléments mémoire au premier niveau de métal. Ceci permet d'améliorer la performance du circuit mémoire.

Un autre avantage du présent mode de réalisation est qu'il permet de réduire la profondeur des tranchées 42 et ainsi améliorer le remplissage des tranchées dans une étape postérieure à l'étape illustrée en figure 6. En effet, plus le ratio entre la largeur et la profondeur d'une tranchée est faible, plus difficile sera son remplissage, ce qui peut engendrer la formation d'un vide ou espace clos, au centre des tranchées, ne comportant pas de matériau de remplissage. Le présent mode de réalisation permet en outre de réduire les risques de formation de ce vide.

Alors que la personne du métier aurait tendance a fournir une couche d'encapsulation 35 avec une densité relativement élevée, typiquement d'au moins 2,4 afin d'augmenter la stabilité de la couche, la résistance de la couche d'encapsulation à la gravure humide et sèche et d'offrir une meilleure barrière à l'hydrogène et à l'oxygène, encore un autre avantage du présent mode de réalisation est que la densité inférieure à 2,2 des couches 35 et 43 permet d'apporter à chaque cellule mémoire M une meilleure stabilité en température et ainsi un meilleur rendement de fabrication et une plus grande fiabilité.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

En particulier, bien que l'on ait décrit des modes de réalisation dans lesquels les cellules mémoires M sont formées entre l'empilement d'interconnexion 21 et les vias 20, les modes de réalisation ne se limitent pas à ce cas particulier. A titre de variante, les cellules mémoires M peuvent être formées au dessus de l'empilement d'interconnexion 21.

Enfin, la mise en oeuvre pratique des modes de réalisation et variantes décrits est à la portée de la personne du métier à partir des indications fonctionnelles données ci-dessus.

## Revendications

1. Dispositif électronique (40) comportant une pluralité de cellules mémoires (M) organisées selon une matrice, formant des lignes et des colonnes,
chaque cellules mémoire (M) comprenant un empilement d'un élément résistif chauffant (27), d'une couche en un matériau à changement de phase (25), d'une électrode supérieure (31) et d'une couche de masquage (43),
la couche en le matériau à changement de phase (25), l'électrode supérieure (31) et la couche de masquage (43), étant commune aux cellules mémoires d'une même ligne et recouverts par une couche d'encapsulation (35), la couche d'encapsulation (35) recouvrant une face supérieure de la couche de masquage (43) et des flancs latéraux de la couche de masquage (43), de l'électrode supérieure (31) et de la couche en le matériau à changement de phase (25),
dans lequel la couche de masquage (43) a une épaisseur inférieure à 15 nm et est en nitrure de silicium

2. Dispositif électronique (40) selon la revendication 1, dans lequel la couche de masquage (43) a une épaisseur de l'ordre de 5 nm.

3. Dispositif électronique (40) selon la revendication 1 ou 2, dans lequel la couche de masquage (43) et la couche d'encapsulation (35) sont en un nitrure de silicium ayant la même stœchiométrie.

4. Dispositif électronique (40) selon l'une quelconque des revendication 1 à 3, dans lequel la couche de masquage (43) et la couche d'encapsulation (35) ont une masse volumique inférieure à 2,2 g/cm³.

5. Dispositif électronique (40) selon l'une quelconque des revendications 1 à 3, dans lequel la couche de masquage (43) ou la couche d'encapsulation (35) est en un empilement de plusieurs sous-couches.

6. Dispositif électronique (40) selon l'une quelconque des revendications 1 à 5, dans lequel la couche de masquage (43) et la couche d'encapsulation (35) sont traversées par un via conducteur, le via conducteur étant en contact avec l'électrode supérieure (31).

7. Procédé de fabrication d'un dispositif électronique (40) comportant une pluralité de cellules mémoires (M) organisées selon une matrice, formant des lignes et des colonnes, le procédé comportant les étapes de :
a) formation d'un empilement d'un élément résistif, d'une couche en un matériau à changement de phase (25) et d'une électrode supérieure (31) ;
b) dépôt d'une couche de masquage (43), en nitrure de silicium, sur l'empilement susmentionné ;
c) gravure de la couche de masquage (43) et de l'empilement de façon à créer, dans la couche en le matériau à changement de phase (25), l'électrode supérieure (31) et la couche de masquage (43), des lignes ; et
d) dépôt d'une couche d'encapsulation (35) recouvrant une face supérieure de la couche de masquage (43) et des flancs latéraux de la couche de masquage (43), de l'électrode supérieure (31) et de la couche en le matériau à changement de phase (25),
dans lequel, à l'issue de l'étape c), la couche de masquage présente une épaisseur inférieure à 15 nm.

8. Procédé selon la revendication 7, dans lequel la couche de masquage (43) est, à l'étape b), déposée selon une méthode de dépôt conforme.

9. Procédé selon la revendication 7 ou 8, dans lequel la couche de masquage (43) est, à l'étape b), déposée selon une méthode de dépôt nanométrique.

10. Procédé selon l'une quelconque des revendications 7 à 9, dans lequel la couche de masquage (43) est, à l'étape b), déposée selon une méthode de dépôt chimique en phase vapeur assisté par plasma, cette méthode étant pulsée.

11. Procédé selon la revendication 10, dans lequel, lors de l'étape b), le plasma est activé par impulsions d'une puissance comprise entre 80 W et 200 W.

12. Procédé selon la revendication 10 ou 11, dans lequel l'étape b) a une durée supérieure à 30 secondes.

13. Procédé selon l'une quelconque des revendications 10 à 12, dans lequel, lors de l'étape b), les impulsions du plasma ont une fréquence comprise entre 800 Hz et 1500 Hz.

14. Procédé selon l'une quelconque des revendications 7 à 13, comportant, entre les étapes b) et c), une étape de traitement thermique de la couche de masquage (25).

15. Procédé selon l'une quelconque des revendications 7 à 12, dans lequel la couche d'encapsulation (35) et la couche de masquage (43) sont déposées selon la même méthode de dépôt.

16. Procédé d'utilisation d'un dispositif électronique (11) selon l'une quelconque des revendications 1 à 6, comportant l'application d'un courant dans l'élément résistif chauffant (29) de l'une des cellules mémoires (M), d'où il résulte un changement de phase cristalline de la couche en le matériau à changement de phase (25) de la cellule mémoire (M), permettant le stockage d'un bit de données.
